# EUROPEAN PATENT APPLICATION

(11) **EP 2 876 627 A1**
(43) Date of publication of application: **27.05.2015**
(21) Application number: 14162881.8
(22) Date of filing: 31.03.2014
(51) Int. Cl.: G09F 3/20, G09F 3/18

(54) **Cover case for electronic shelf label and electronic shelf label**

(30) Priority: 20.11.2013 KR 20130141443
(71) Applicant: Samsung Electro-Mechanics Co., Ltd., Suwon-Si, Gyeonggi-Do 443-743 (KR)
(72) Inventor: Kang, Yeon Hee, 443-743 Gyeonggi-Do (KR); You, Min Su, 443-743 Gyeonggi-Do (KR)
(74) Representative: Potter Clarkson LLP

(57) **Abstract**

The present invention relates to a cover case for an electronic shelf label and an electronic shelf label.

A cover case for an electronic shelf label according to the present invention includes: a front cover(110) for covering a front of a circuit unit including a display portion (140) for displaying product information; and a back cover (120) for covering a back of the circuit unit, wherein the front cover (110) and the back cover (120) are coupled with each other so that a first separation portion for inserting a label having product information printed thereon is formed in an upper portion thereof and a second separation portion is formed in a lower portion thereof while being coupled with each other in a state of receiving the circuit unit, and a projecting portion is formed in at least one of lower portions of the front cover (110) and the back cover (120).

## Description

### CROSS-REFERENCE TO RELATED APPLICATIONS

Claim and incorporate by reference domestic priority application and foreign priority application as follows:

### "CROSS REFERENCE TO RELATED APPLICATION

This application claims the foreign priority benefit of Korean Patent Application Serial No. 10-2013-0141443, filed November 20, 2013, which is hereby incorporated by reference in its entirety into this application."

### BACKGROUND OF THE INVENTION

### 1. Field of the Invention

The present invention relates to a cover case for an electronic shelf label and an electronic shelf label.

### 2. Description of the Related Art

A great number of product shelves are installed in stores, such as department stores and large stores, which sell various kinds of products in large quantities, to display various products organized by category.

And a display device, which lists product information such as name and price, is attached to the front of the product shelf on which each product is displayed to allow consumers to buy the desired product.

However, as the size of the store is gradually increased, the kind and quantity of products requiring management are also increased. Therefore, it is virtually impossible for a manager to directly manage the price of all products through manual work as in the past.

In order to overcome this problem, in recent times, researches on a technology that introduces an electronic shelf label (ESL) to manage information about various products through an electronic control device and transmit the product information to the electronic label, which displays the product, through wireless communication have been actively conducted.

In the ESL, a separate label is inserted along with a segment LCD type display device which displays the product information, and the product information such as product name and barcode is printed on the label.

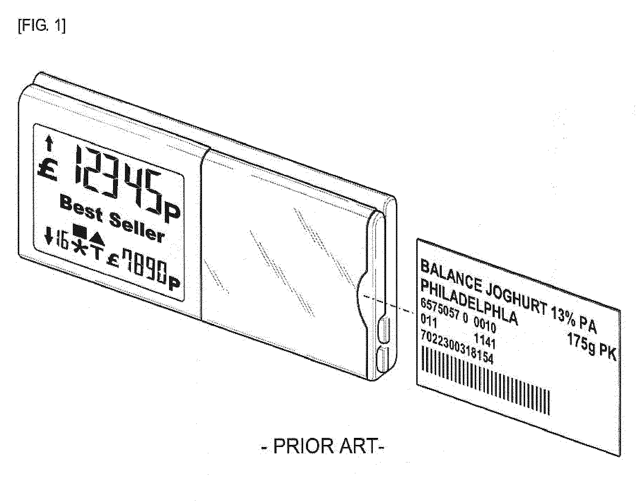

As for the label, as shown in FIG. 1, generally, a method of inserting a label from the side may be employed, but it is not easy to insert the label compared to a method of inserting a label from the top and the label slips to the side frequently.

Thus, in recent times, the above method of inserting a label from the top has been highlighted, but in the above method of inserting a label from the top, since the bottom of a label insertion space is blocked, foreign materials such as dust are piled in the label insertion space.

Therefore, above all, it is needed to develop a cover case and an ESL including the same that can improve satisfaction of users (store employees, consumers, etc.) by discharging foreign materials such as dust as well as facilitating insertion of a label etc.

### [Related Art Document]

### [Patent Document]

Patent Document 1: Korean Patent Laid-Open Publication No. 2010-0019106

### SUMMARY OF THE INVENTION

The present invention has been invented in order to overcome the above-described problems and it is, therefore, an object of the present invention to provide a cover case for an electronic shelf label and an electronic shelf label that can discharge foreign materials such as dust as well as facilitate insertion of a label etc.

In accordance with one aspect of the present invention to achieve the object, there is provided a cover case for an electronic shelf label, including: a front cover for covering a front surface of a circuit unit including a display portion for displaying product information; and a back cover for covering a back surface of the circuit unit, wherein the front cover and the back cover may be coupled with each other so that a first separation portion for inserting a label having product information printed thereon is formed in an upper portion thereof and a second separation portion is formed in a lower portion thereof while being coupled with each other in a state of receiving the circuit unit, and a projecting portion may be formed in at least one of a lower portion of the front cover and a lower portion of the back cover.

Further, in accordance with another aspect of the present invention to achieve the object, there is provided an electronic shelf label including: a circuit unit including a display portion for displaying product information; and a cover case for detachably receiving the circuit unit, wherein the cover case may include a front cover for covering a front surface of the display portion; and a back cover for covering a back surface of the display portion, wherein the front cover and the back cover may be coupled with each other so that a first separation portion for inserting a label having product information printed thereon is formed in an upper portion thereof and a second separation portion is formed in a lower portion thereof while being coupled with each other in a state of receiving the circuit unit, and a projecting portion may be formed in at least one of a lower portion of the front cover and a lower portion of the back cover.

In an embodiment of the present invention, one or more projecting portions may be formed in the lower portion of the front cover to project toward the back cover.

In an embodiment of the present invention, the front cover may include a display cover formed in a position facing the display portion; and a label cover formed in a position facing the inserted label.

In an embodiment of the present invention, the first separation portion may be formed in an upper portion of the label cover, the second separation portion may be formed in a lower portion of the label cover, and the projecting portion may be formed to project from the lower portion of the label cover toward the back cover.

In an embodiment of the present invention, side surfaces of the front cover and the back cover may be coupled with each other.

In an embodiment of the present invention, the front cover and the back cover may be coupled with each other to seal the display portion.

In an embodiment of the present invention, the lower portion of the front cover may have a round shape.

In an embodiment of the present invention, the lower portion of the label cover may have a round shape.

In another embodiment of the present invention, one or more projecting portions may be formed in the lower portion of the back cover to project toward the front cover.

In another embodiment of the present invention, the front cover may include a display cover formed in a position facing the display portion; and a label cover formed in a position facing the inserted label.

In another embodiment of the present invention, the first separation portion may be formed in the upper portion of the label cover, the second separation portion may be formed in the lower portion of the label cover, and the projecting portion may be formed to project from the lower portion of the back cover toward the label cover.

In another embodiment of the present invention, side surfaces of the front cover and the back cover may be coupled with each other.

In another embodiment of the present invention, the front cover and the back cover may be coupled with each other to seal the display portion.

In another embodiment of the present invention, the lower portion of the front cover may have a round shape.

In another embodiment of the present invention, the lower portion of the label cover may have a round shape.

In another embodiment of the present invention, one or more projecting portions may be formed in the lower portion of the front cover and the lower portion of the back cover and include a first projecting portion formed to project from the lower portion of the front cover toward the back cover and a second projecting portion formed to project from the lower portion of the back cover toward the front cover.

In another embodiment of the present invention, the front cover may include a display cover formed in a position facing the display portion; and a label cover formed in a position facing the inserted label.

In another embodiment of the present invention, the first separation portion may be formed in the upper portion of the label cover, the second separation portion may be formed in the lower portion of the label cover, the first projecting portion may be formed to project from the lower portion of the label cover toward the back cover, and the second projecting portion may be formed to project from the lower portion of the back cover toward the label cover.

In another embodiment of the present invention, side surfaces of the front cover and the back cover may be coupled with each other.

In another embodiment of the present invention, the front cover and the back cover may be coupled with each other to seal the display portion.

In another embodiment of the present invention, the lower portion of the front cover may have a round shape.

In another embodiment of the present invention, the lower portion of the label cover may have a round shape.

In another embodiment of the present invention, the first projecting portion and the second projecting portion may be coupled with each other.

In another embodiment of the present invention, the front cover may include a display cover formed in a position facing the display portion; and a label cover formed in a position facing the inserted label.

In another embodiment of the present invention, the first separation portion may be formed in the upper portion of the label cover, the second separation portion may be formed in the lower portion of the label cover, the first projecting portion may be formed to project from the lower portion of the label cover toward the back cover, and the second projecting portion may be formed to project from the lower portion of the back cover toward the label cover.

In another embodiment of the present invention, side surfaces of the front cover and the back cover may be coupled with each other.

In another embodiment of the present invention, the front cover and the back cover may be coupled with each other to seal the display portion.

In another embodiment of the present invention, the lower portion of the front cover may have a round shape.

In another embodiment of the present invention, the lower portion of the label cover may have a round shape.

### BRIEF DESCRIPTION OF THE DRAWINGS

These and/or other aspects and advantages of the present general inventive concept will become apparent and more readily appreciated from the following description of the embodiments, taken in conjunction with the accompanying drawings of which:
FIG. 1 is a view showing a structure in which a label having a product name, a barcode, etc. printed thereon is inserted from the side;
FIG. 2 is a perspective view schematically showing a cover case for an electronic shelf label in accordance with a first embodiment of the present invention;
FIG. 3 is an exploded perspective view schematically showing the cover case for an electronic shelf label shown in FIG. 2;
FIG. 4 is a bottom view schematically showing the cover case for an electronic shelf label shown in FIG. 2;
FIG. 5 is a side view schematically showing a portion of the cover case for an electronic shelf label shown in FIG. 2;
FIG. 6 is a perspective view schematically showing a cover case for an electronic shelf label in accordance with a second embodiment of the present invention;
FIG. 7 is an exploded perspective view schematically showing the cover case for an electronic shelf label shown in FIG. 6;
FIG. 8 is a bottom view schematically showing the cover case for an electronic shelf label shown in FIG. 6;
FIG. 9 is a perspective view schematically showing a cover case for an electronic shelf label in accordance with a third embodiment of the present invention;
FIG. 10 is an exploded perspective view schematically showing the cover case for an electronic shelf label shown in FIG. 9;
FIG. 11 is a bottom view schematically showing the cover case for an electronic shelf label shown in FIG. 9;
FIG. 12 is a perspective view schematically showing a cover case for an electronic shelf label in accordance with a fourth embodiment of the present invention;
FIG. 13 is an exploded perspective view schematically showing the cover case for an electronic shelf label shown in FIG. 12;
FIG. 14 is a bottom view schematically showing the cover case for an electronic shelf label shown in FIG. 12; and
FIG. 15 is a configuration diagram schematically showing a system network using an electronic shelf label in accordance with an embodiment of the present invention.

### DETAILED DESCRIPTION OF THE PREFERABLE EMBODIMENTS

A matter regarding to an operational effect including a technical configuration for an object of a cover case for an electronic shelf label and an electronic shelf label in accordance with the present invention will be clearly appreciated through the following detailed description with reference to the accompanying drawings showing preferable embodiments of the present invention.

Further, in describing the present invention, descriptions of well-known techniques are omitted so as not to unnecessarily obscure the embodiments of the present invention. In the present specification, the terms "first," "second," and the like are used for distinguishing one element from another, and the elements are not limited by the above terms.

### Cover case for electronic shelf label

### <First embodiment>

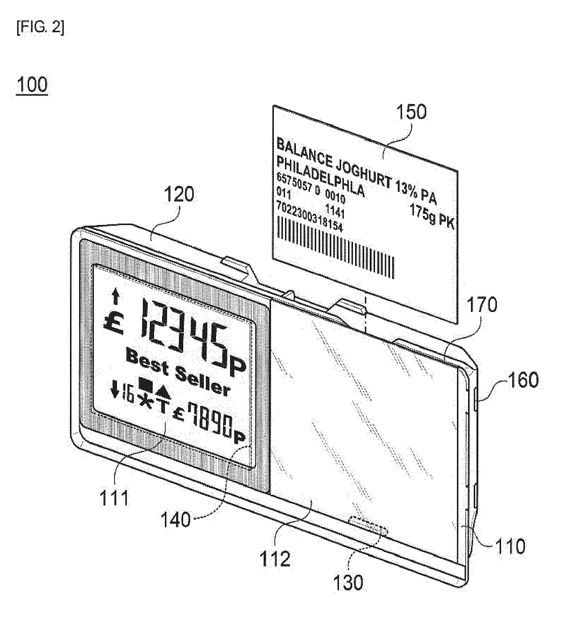

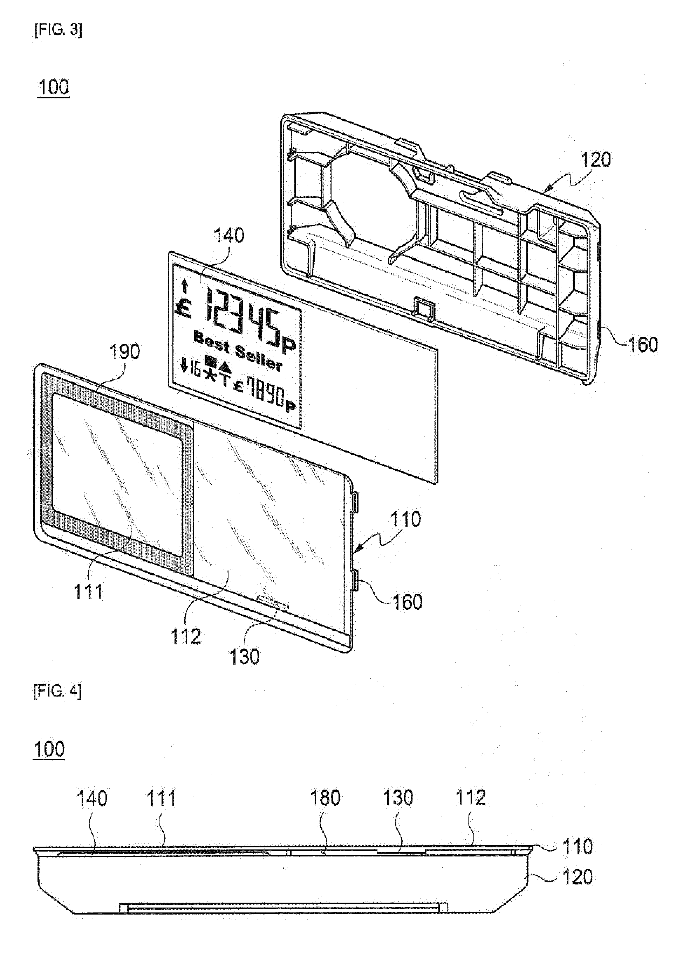

FIG. 2 is a perspective view schematically showing a cover case 100 for an electronic shelf label in accordance with a first embodiment of the present invention, FIG. 3 is an exploded perspective view schematically showing the cover case 100 for an electronic shelf label shown in FIG. 2, and FIG. 4 is a bottom view schematically showing the cover case 100 for an electronic shelf label shown in FIG. 2.

As shown in FIGS. 2 to 4, the cover case 100 for an electronic shelf label according to the present embodiment may include a front cover 110, a back cover 120, and a projecting portion 130.

The front cover 110, as shown in FIGS. 2 to 4, may cover a front surface of a circuit unit including a display portion 140 for displaying information of the product.

In this case, the front cover 110, as shown in FIGS. 2 to 4, may include a display cover 111 and a label cover 112.

As shown in FIGS. 2 to 4, the display cover 111, which protects the display portion 140, may be formed in a position facing the display portion 140 while being formed on one side of the front cover 110.

As shown in FIGS. 2 to 4, the label cover 112, in which a label 150 having a product name, a barcode, etc. printed thereon is inserted, may be formed in a position facing the inserted label 150 while being formed on the other side of the front cover 110.

At this time, the display cover 111 and the label cover 112 of the present embodiment may be made of a transparent plastic resin, but the present invention is not limited thereto.

However, in case of the present embodiment, the display cover 111 and the label cover 112 are made of a transparent plastic resin to allow users (store employees, consumers, etc.) to easily recognize the information displayed on the display portion 140, such as product price and unit cost, and the information printed on the label 150, such as product name and barcode, from the outside.

Meanwhile, the back cover 120, as shown in FIGS. 2 to 4, may cover a back surface of the circuit unit including the display portion 140.

Here, the back cover 120 may be made of a transparent or opaque plastic resin, but the present invention is not limited thereto and may use any material that can receive the circuit unit including the display portion 140 through coupling with the front cover 110.

In the present embodiment, through the mutual coupling between the front cover 110 and the back cover 120 as above, it is possible to detachably receive the circuit unit including the display portion 140.

In this case, the front cover 110 and the back cover 120, as shown in FIGS. 2 and 3, may be coupled with each other in a state of receiving the circuit unit including the display portion 140.

The present embodiment employs a method of coupling side surfaces of the front cover 110 and the back cover 120 with each other through a lock means 160 using a groove, a projection, etc., but the present embodiment is not limited thereto. If the front cover 110 and the back cover 120 can be coupled with each other in a state of receiving the circuit unit, various applications, such as coupling of at least one of upper and lower portions through hinge coupling, coupling using an adhesive applied along an adhesive surface, screw coupling using a screw hole, etc., are possible.

At this time, the front cover 110 and the back cover 120 may be coupled with each other to seal the display portion 140.

That is, in the present embodiment, as shown in FIG. 3, a seal member 190 may be formed between the front cover 110, for example, the display cover 111 and the display portion 140, and the front cover 110 having the seal member 190 may be coupled with the back cover 120 to seal the display portion 140.

However, the present invention is not limited to the above, and various applications, such as formation of an epoxy mold compound (EMC) molding member, an adhesive member, etc. in the front cover 110 or the back cover 120, are possible if the display portion 140 can be sealed.

Meanwhile, back to FIG. 2 again, the front cover 110 and the back cover 120 of the present embodiment may be coupled with each other so that a first separation portion 170, which can insert the label 150 therein, is formed in an upper portion of the cover case 100, for example, in an upper portion of the label cover 112 in which the label 150 is inserted as in the present embodiment.

Through the first separation portion 170 formed in the upper portion as above, in the cover case 100 of the present embodiment, the label 150 can be inserted or detached from the top.

Therefore, since the cover case 100 of the present embodiment can facilitate the insertion of the label, etc. than the case of inserting the label from the side and also can reduce the risk of loss of the label by preventing the label 150 from slipping to the side.

Further, as shown in FIGS. 2 and 4, the front cover 110 and the back cover 120 may be coupled with each other so that a second separation portion 180 is formed in an lower portion of the cover case 100, for example, in a lower portion of the label cover 112 in which the label 150 is inserted while forming the first separation portion 170 in the upper portion of the cover case 100.

By forming the second separation portion 180 as above, the cover case 100 of the present embodiment can discharge foreign materials such as dust through the second separation portion 180 formed in the lower portion thereof as well as insert the label 150 from the top through the first separation portion 170.

Therefore, the cover case 100 of the present embodiment can prevent foreign materials such as dust from being piled in the insertion space of the label 150, for example, in the label cover 112. Accordingly, it is possible to improve the beauty of the space and label readability, consequently improving the satisfaction of the users (store employees, consumers, etc.).

However, since the cover case 100 of the present embodiment, as described above, has the separation spaces (first separation portion, second separation portion) in both of the upper and lower portions thereof, if there is no configuration for fixing the inserted label 150 in the lower portion thereof, the label 150 inserted through the first separation portion 170 slips down through the second separation portion 180.

Therefore, in the cover case 100 of the present embodiment, since the projecting portion 130 is formed in the lower portion of the front cover 110 to thereby fix the bottom of the label 150 which is inserted from the top, it is possible to prevent the label 150 inserted through the first separation portion 170 from slipping down through the second separation portion 180.

That is, in the present embodiment, as shown in FIGS. 2 to 4, the projecting portion 130 is formed in the lower portion of the front cover 110, for example, in the lower portion of the label cover 112 in which the label 150 is inserted and projects from the lower portion of the label cover 112 toward the back cover 120 to fix the label 150, which is inserted from the top through the first separation portion 170, in the lower portion of the cover case 110.

Here, although the present embodiment employs a configuration in which one projecting portion 130 is formed in the lower portion of the front cover (label cover), the present invention is not limited thereto and allows various applications such as formation of a plurality of projecting portions if it is possible to fix the label 150, which is inserted through the first separation portion 170, in the lower portion.

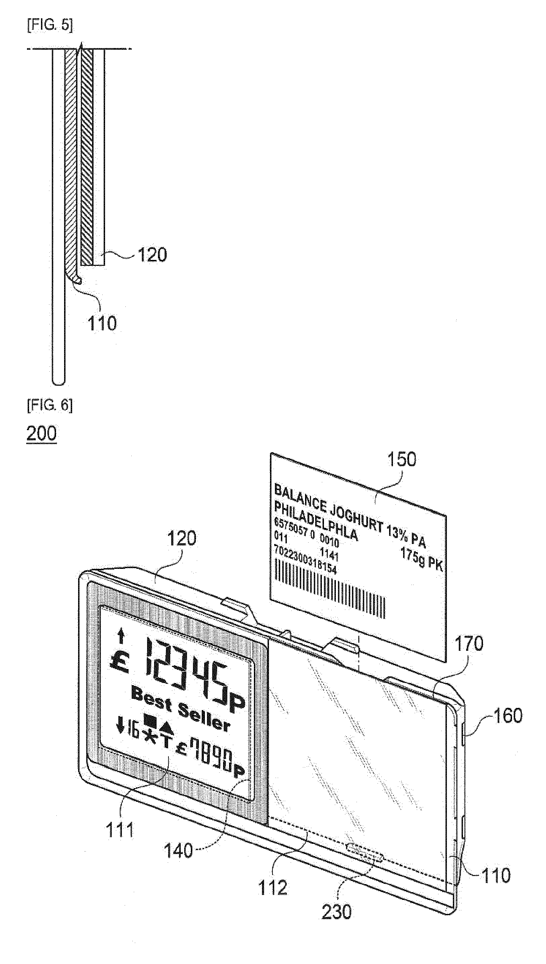

Further, FIG. 5 is a side view schematically showing a portion of the cover case for an electronic shelf label shown in FIG. 2. In the present embodiment, as shown in FIG. 5, the lower portion of the front cover 110, for example, the lower portion of the label cover, which is a space for inserting the label 150, may be formed in a round shape, but the present invention is not limited thereto.

Like the present embodiment shown in FIG. 5, the shape in which the lower portion of the front cover 110, for example, the lower portion of the label cover is rounded toward the back cover 120 can have a label fixing function similar to the projecting portion 130. Therefore, it is possible to further improve a label fixing function than the cover case employing only the projecting portion 130.

### <Second embodiment>

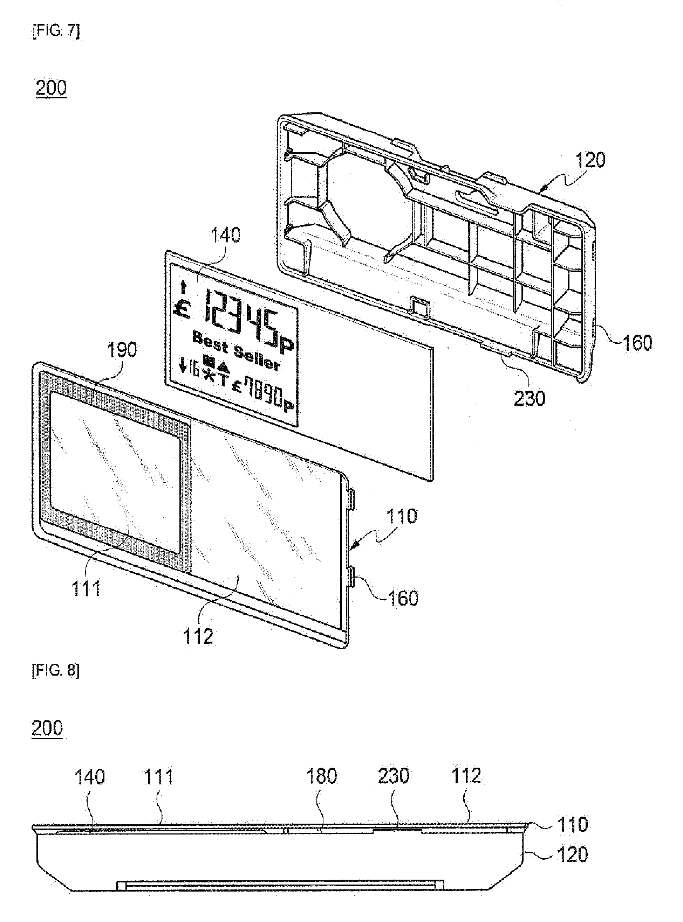

FIG. 6 is a perspective view schematically showing a cover case 200 for an electronic shelf label in accordance with a second embodiment of the present invention, FIG. 7 is an exploded perspective view schematically showing the cover case 200 for an electronic shelf label shown in FIG. 6, and FIG. 8 is a bottom view schematically showing the cover case 200 for an electronic shelf label shown in FIG. 6.

As shown in FIGS. 6 to 8, the cover case 200 for an electronic shelf label according to the present embodiment may include a front cover 110, a back cover 120, and a projecting portion 230 like the first embodiment.

In the cover case 200 for an electronic shelf label according to the present embodiment, elements (front cover, display cover, label cover, back cover, display portion, label, coupling configuration of front cover and back cover (including lock means, coupling configuration to seal display portion, etc.) first separation portion, second separation portion, etc.), which are the same as those of the cover case 100 for an electronic shelf label of the first embodiment, will be represented by the same reference numerals and descriptions thereof will be omitted.

Therefore, hereinafter, elements (projection portion 230 etc.) which are different from those of the cover case 100 for an electronic shelf label of the first embodiment will be mainly described.

Since the cover case 200 of the present embodiment has separation spaces (first separation portion, second separation portion) in upper and lower portions thereof like the cover case 100 of the first embodiment, when there is no configuration for fixing an inserted label 150 in the lower portion thereof, the label 150 inserted through a first separation portion 170 slips down through a second separation portion 180.

Therefore, the cover case 200 of the present embodiment also has the projecting portion 230 for preventing the label 150 from slipping down like the first embodiment. In this case, in the cover case 200 of the present embodiment, unlike the first embodiment, the projecting portion 230 may be formed in a lower portion of the back cover 120 to thereby prevent the label 150 inserted through the first separation portion 170 from slipping down through the second separation portion 180.

That is, in the present embodiment, as shown in FIGS. 6 to 8, the projecting portion 230 may be formed in the lower portion of the back cover 120 to project from the lower portion of the back cover 120 toward the front cover 110, for example, toward a label cover 112, thus fixing the label 150, which is inserted from the top through the first separation portion 170, In the lower portion of the cover case 200.

Here, although the present embodiment employs a configuration in which one projecting portion 230 is formed in the lower portion of the back cover 120, the present invention is not limited thereto and allows various applications such as formation of a plurality of projecting portions if it is possible to fix the label 150, which is inserted through the first separation portion 170, in the lower portion.

Further, in the present embodiment, like the first embodiment, a lower portion of the front cover 110, for example, a lower portion of the label cover, which is a space for inserting the label 150, may be formed in a round shape (refer to FIG. 5), but the present invention is not limited thereto.

As already described in the first embodiment, the shape in which the lower portion of the front cover 110, for example, the lower portion of the label cover is rounded toward the back cover 120 can have a label fixing function similar to the projecting portion 230 of the present embodiment. Therefore, it is possible to further improve a label fixing function than the cover case employing only the projecting portion 230.

### <Third embodiment>

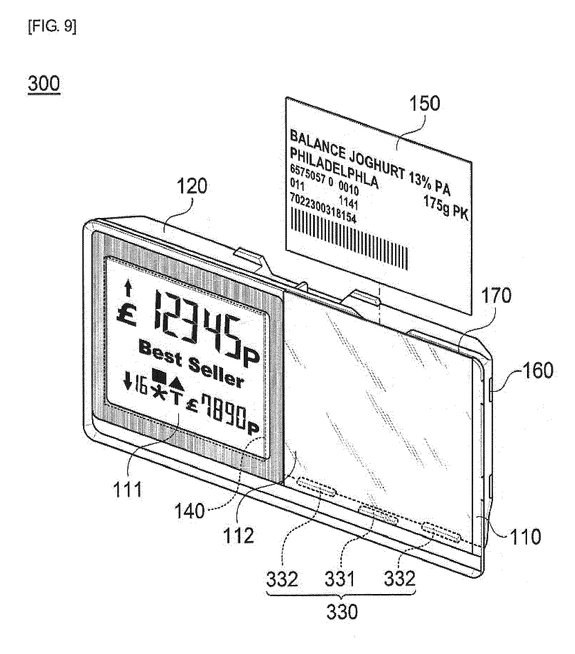

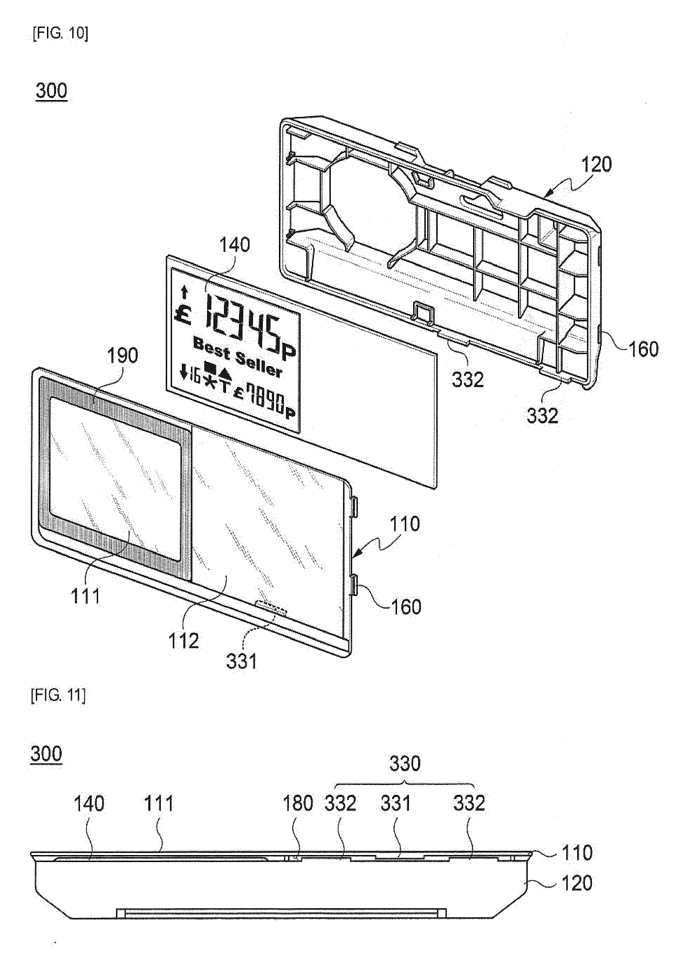

FIG. 9 is a perspective view schematically showing a cover case 300 for an electronic shelf label in accordance with a third embodiment of the present invention, FIG. 10 is an exploded perspective view schematically showing the cover case 300 for an electronic shelf label shown in FIG. 9, and FIG. 11 is a bottom view schematically showing the cover case 300 for an electronic shelf label shown in FIG. 9.

As shown in FIGS. 9 to 11, the cover case 300 for an electronic shelf label according to the present embodiment may include a front cover 110, a back cover 120, and a projecting portion 330 like the first and second embodiments.

In the cover case 300 for an electronic shelf label according to the present embodiment, elements (front cover, display cover, label cover, back cover, display portion, label, coupling configuration of front cover and back cover (including lock means, coupling configuration to seal display portion, etc.) first separation portion, second separation portion, etc.), which are the same as those of the cover cases 100 and 200 for an electronic shelf label of the first and second embodiments, will be represented by the same reference numerals and descriptions thereof will be omitted.

Therefore, hereinafter, elements (projecting portion 330 etc.) which are different from those of the cover cases 100 and 200 for an electronic shelf label of the first and second embodiments will be mainly described.

Since the cover case 300 of the present embodiment has separation spaces (first separation portion, second separation portion) in upper and lower portions thereof like the cover cases 100 and 200 of the first and second embodiments, when there is no configuration for fixing an inserted label 150 in the lower portion thereof, the label 150 inserted through a first separation portion 170 slips down through a second separation portion 180.

Therefore, the cover case 300 of the present embodiment also has the projecting portion 330 for preventing the label 150 from slipping down like the first and second embodiments. In this case, in the cover case 300 of the present embodiment, unlike the first and second embodiments, the projecting portions 330 may be formed in lower portions of the front cover 110 and the back cover 120 to thereby prevent the label 150 inserted through the first separation portion 170 from slipping down through the second separation portion 180.

That is, in the present embodiment, as shown in FIGS. 9 to 11, the projecting portions 330 may be formed in the lower portions of the front cover 110 and the back cover 120. In this case, the projecting portions 330 may include a first projecting portion 331 and a second projecting portion 332.

The first projecting portion 331, as shown in FIGS. 9 to 11, may be formed to project from the lower portion of the front cover 110, for example, from a lower portion of a label cover 112, in which the label 150 is inserted, toward the back cover 120.

Further, the second projecting portion 332, as shown in FIGS. 9 to 11, may be formed to project from the lower portion of the back cover 120 toward the front cover 110, for example, toward the label cover 112.

The cover case 300 of the present embodiment has the projecting portions 330, which are formed as above, that is, the first projecting portion 331 formed in the lower portion of the front cover 110 and the second projecting portion 332 formed in the lower portion of the back cover 120, thus fixing the label 150, which is inserted from the top through the first separation portion 170, in the lower portion of the cover case 300.

Here, although the present embodiment employs a configuration in which one first projecting portion 331 is formed in the lower portion of the front cover 110 and a plurality of second projecting portions 332 are formed in the lower portion of the back cover 120, the present invention is not limited thereto and allows various applications such as formation of one or a plurality of first projecting portions and one or a plurality of second projecting portions if it is possible to fix the label 150, which is inserted through the first separation portion 170, in the lower portion.

Further, in the present embodiment, like the first and second embodiments, the lower portion of the front cover 110, for example, the lower portion of the label cover, which is a space for inserting the label 150, may be formed in a round shape (refer to FIG. 5), but the present invention is not limited thereto.

As already described in the first and second embodiments, the shape in which the lower portion of the front cover 110, for example, the lower portion of the label cover is rounded toward the back cover 120 can have a label fixing function similar to the projecting portion 330 of the present embodiment. Therefore, it is possible to further improve a label fixing function than the cover case employing only the projecting portion 330.

### <Fourth embodiment>

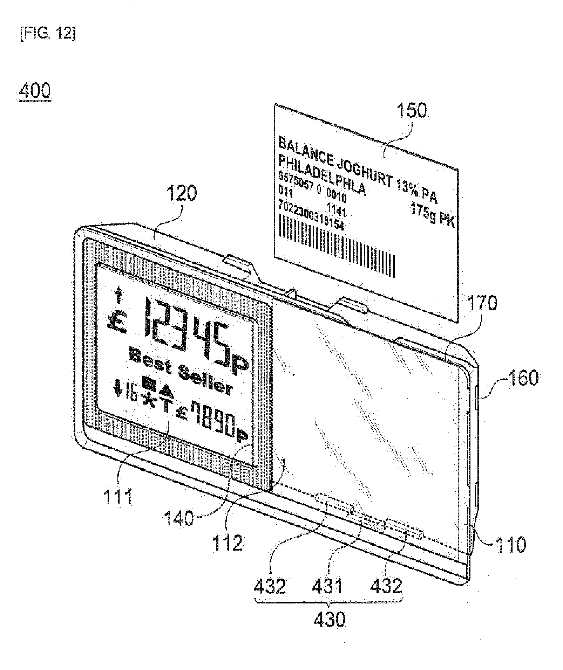

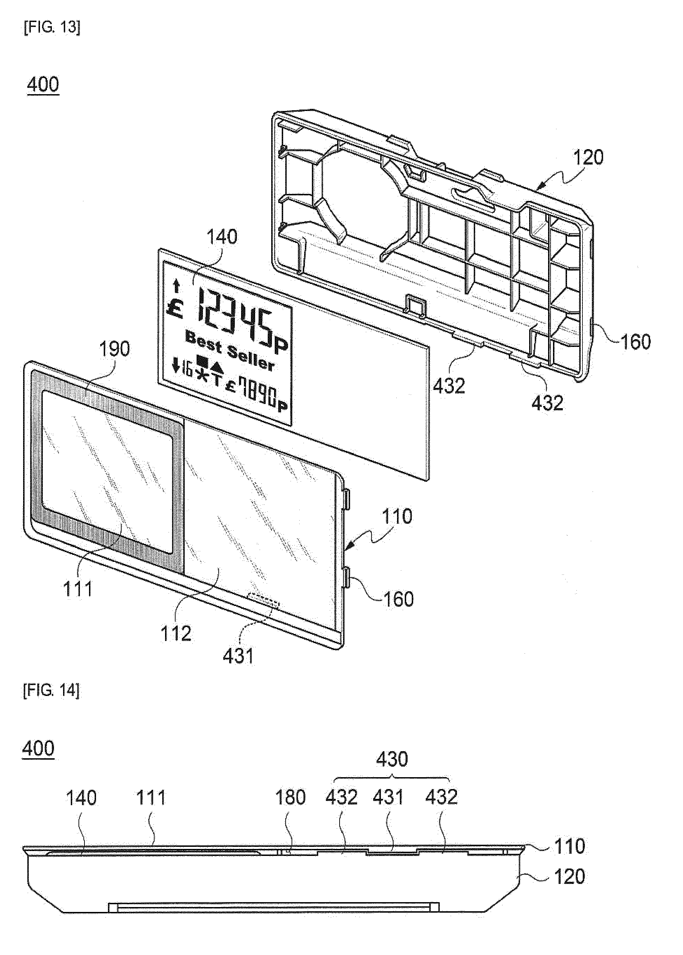

FIG. 12 is a perspective view schematically showing a cover case 400 for an electronic shelf label in accordance with a fourth embodiment of the present invention, FIG. 13 is an exploded perspective view schematically showing the cover case 400 for an electronic shelf label shown in FIG. 12, and FIG. 14 is a bottom view schematically showing the cover case 400 for an electronic shelf label shown in FIG. 12.

As shown in FIGS. 12 to 14, the cover case 400 for an electronic shelf label according to the present embodiment may include a front cover 110, a back cover 120, and a projecting portion 430 like the first to third embodiments.

In the cover case 400 for an electronic shelf label according to the present embodiment, elements (front cover, display cover, label cover, back cover, display portion, label, coupling configuration of front cover and back cover (including lock means, coupling configuration to seal display portion, etc.) first separation portion, second separation portion, etc.), which are the same as those of the cover cases 100, 200, and 300 for an electronic shelf label of the first to third embodiments, will be represented by the same reference numerals and descriptions thereof will be omitted.

Therefore, hereinafter, elements (projection portion 430 etc.) which are different from those of the cover cases 100, 200, and 300 for an electronic shelf label of the first to third embodiments will be mainly described.

Since the cover case 400 of the present embodiment has separation spaces (first separation portion, second separation portion) in upper and lower portions thereof like the cover cases 100, 200, and 300 of the first to third embodiments, when there is no configuration for fixing an inserted label 150 in the lower portion thereof, the label 150 inserted through a first separation portion 170 slips down through a second separation portion 180.

Therefore, the cover case 400 of the present embodiment also has the projecting portion 430 for preventing the label 150 from slipping down like the first to third embodiments.

In this case, in the cover case 400 of the present embodiment, unlike the first to third embodiments, the projecting portion 430 may be formed by coupling a first projecting portion 431 formed in a lower portion of the front cover 110 with a second projecting portion 432 formed in a lower portion of the back cover 120 to thereby prevent the label 150 inserted through the first separation portion 170 from slipping down through the second separation portion 180.

That is, as shown in FIGS. 12 to 14, as in the third embodiment, the projecting portion 430 of the present embodiment may include the first projecting portion 431 formed to project from the lower portion of the front cover 110, for example, from a lower portion of a label cover 112, in which the label 150 is inserted, toward the back cover 120 and the second projecting portion 432 formed to project from the lower portion of the back cover 120 toward the front cover 110, for example, toward the label cover 112.

However, unlike the third embodiment, the first projecting portion 431 and the second projecting portion 432 of the present embodiment may be coupled with each other as shown in FIGS. 12 to 14.

In the cover case 400 of the present embodiment, through the projecting portion 430 formed as above, that is, through the projecting portion 430 formed by coupling the first projecting portion 431 formed in the lower portion of the front cover 110 with the second projecting portion 432 formed in the lower portion of the back cover 120, it is possible to fix the label 150, which is inserted from the top through the first separation portion 170, in the lower portion of the cover case 400.

Here, although the present embodiment employs a configuration in which one first projecting portion 431 is formed in the lower portion of the front cover 110 and a plurality of second projecting portions 432 are formed in the lower portion of the back cover 120 like the third embodiment, the present invention is not limited thereto and allows various applications such as formation of one or a plurality of first projecting portions and one or a plurality of second projecting portions if it is possible to fix the label 150, which is inserted through the first separation portion 170, in the lower portion.

Further, in the present embodiment, like the first to third embodiments, the lower portion of the front cover 110, for example, the lower portion of the label cover, which is a space for inserting the label 150, may be formed in a round shape (refer to FIG. 5), but the present invention is not limited thereto.

As already described in the first to third embodiments, the shape in which the lower portion of the front cover 110, for example, the lower portion of the label cover is rounded toward the back cover 120 can have a label fixing function similar to the projecting portion 430 of the present embodiment. Therefore, it is possible to further improve a label fixing function than the cover case employing only the projecting portion 430.

### Electronic shelf label

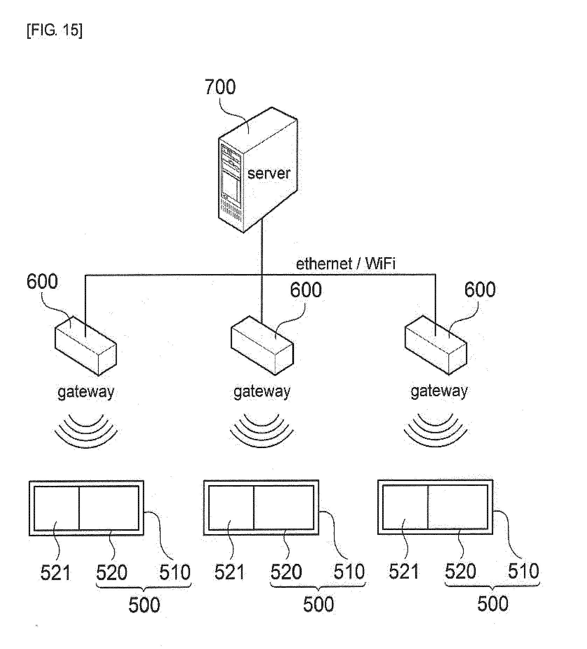

FIG. 15 is a configuration diagram schematically showing a system network using an electronic shelf label 500 in accordance with an embodiment of the present invention.

As shown in FIG. 15, the electronic shelf label 500 of the present embodiment is mounted on shelves of stores such as department stores, large stores, and general stores to display product information such as price.

The electronic shelf label 500, as shown in FIG. 15, may communicate with a server 700 through a nearby gateway 600 among a plurality of gateways.

A console may be connected to the server 700 and a store manager can control the server 700 through the console and control the gateway 600 and the electronic shelf label 500 which communicate with the server 700.

In this case, the store manager may transmit the product information which are to be displayed on the electronic shelf label 500, such as price, product image, discount information, and barcode, through the server 700 to display the product information on the electronic shelf label 500.

The server 700 and the gateway 600 may be connected in a wired or wireless manner and communicate with each other, for example, through Ethernet, WiFi, etc.

Further, the gateway 600 and the electronic shelf label 500 may be connected in a wireless manner, for example, through Zigbee, WiFi, and ultra wide band (UWB) communication.

Further, each electronic shelf label 500 according to the present embodiment has unique identification (ID) information, and the server 700 may use the unique ID as an address when communicating with the electronic shelf label 500.

The unique ID is set when the store manager installs the electronic shelf label 500 on the shelves of the store first. The store manager gives the unique ID to the electronic shelf label 500 using a handheld device etc. and registers the unique ID in the server 700.

Once the electronic shelf label 500 is registered in the server 700, the store manager changes the image displayed on the electronic shelf label 500 through the server 700 and transmits various control commands to control the electronic shelf label 500.

As shown in FIG. 15, the electronic shelf label 500 of the present embodiment, which is used in the above exemplary network etc, may include a cover case 510 and a circuit unit 520 which includes a display portion 521.

At this time, the cover case 510 may employ the cover cases 100, 200, 300, and 400 according to the first to fourth embodiments of the present invention and configuration thereof is overlapped with the foregoing description. Thus, description thereof will be omitted.

The circuit unit 520 of the present embodiment may include a power supply (not shown) for driving the display portion 521 etc. and a controller (not shown) for controlling the product information received from the server 700 or the product information transmitted from the barcode etc. printed on the label to display the product information on the display portion 521.

Further, the circuit unit 520, as shown in FIG 15, may include the display portion 521 that can display the product information in real time.

At this time, the product information displayed on the display portion 521 may include various data such as number (inventory) of products, sales unit, weight, date of production (manufacture), expiration date, ambient temperature, and products that offer discounts or giveaways as well as price information such as selling price, unit cost, and discount price of products.

As described above, the cover case for an electronic shelf label and the electronic shelf label, which include the above configuration, can implement both of a configuration for inserting a label having a product name, a barcode, etc. printed thereon from the top and a configuration for discharging foreign materials such as dust.

Therefore, it is possible to reduce the risk of loss of the label as well as facilitate the insertion of the label than a method of inserting a label from the side by employing the configuration for inserting the label from the top.

In addition, it is possible to prevent foreign materials such as dust from being piled in the insertion space of the label by employing the configuration for discharging the foreign materials such as dust. Therefore, it is possible to improve the satisfaction of users (store employees, consumers, etc.) by improving the beauty of the space and label readability.

The functions of the various elements shown in the drawings may be provided through the use of dedicated hardware as well as hardware capable of executing software in association with appropriate software. When provided by a processor, the functions may be provided by a single dedicated processor, by a single shared processor, or by a plurality of individual processors, some of which may be shared.

Moreover, explicit use of the term "controller" should not be construed to refer exclusively to hardware capable of executing software, and may implicitly include, without limitation, microprocessor (MCU), digital signal processor (DSP) hardware, read-only memory (ROM) for storing software, random access memory (RAM), and non-volatile storage.

In the claims hereof, any element expressed as a means for performing a specified function is intended to encompass any way of performing a specified function.

Reference in the specification to "an embodiment" of the present principles, as well as other variations thereof, means that a particular feature, structure, characteristic, and so forth described in connection with the embodiment is included in at least one embodiment of the present principles. Thus, the appearances of the phrase "in an embodiment", as well as any other variations, appearing in various places throughout the specification are not necessarily all referring to the same embodiment.

Reference in the specification to "connect" or "connecting", as well as other variations thereof, means that an element is directly connected to the other element or indirectly connected to the other element through another element. Throughout this specification, the singular form includes the plural form unless the context clearly indicates otherwise. When terms "comprises" and/or "comprising" used herein do not preclude existence and addition of another component, step, operation and/or device, in addition to the above-mentioned component, step, operation and/or device.

Further, throughout this specification, the singular form includes the plural form unless the context clearly indicates otherwise. When terms "comprises" and/or "comprising" used herein do not preclude existence and addition of another component, step, operation and/or device, in addition to the above-mentioned component, step, operation and/or device.

So far the preferable embodiments of the present invention have been described. All the embodiments and conditional examples disclosed through the specification are intended to help those skilled in the art to understand the principles and concepts of the present invention, and it will be appreciated by those skilled in the art that the present invention can be implemented in a modified form without departing from the essential characteristics of the present invention. Therefore, the embodiments should be considered in descriptive sense and not for purpose of limitation. The scope of the present invention is defined by the appended claims rather than the foregoing description, and all differences within the scope will be construed as being included in the present invention.

## Claims

1. A cover case for an electronic shelf label, comprising:
a front cover for covering a front surface of a circuit unit comprising a display portion for displaying product information; and
a back cover for covering a back surface of the circuit unit, wherein
the front cover and the back cover are coupled with each other so that a first separation portion for inserting a label having product information printed thereon is formed in an upper portion thereof and a second separation portion is formed in a lower portion thereof while being coupled with each other in a state of receiving the circuit unit, and
a projecting portion is formed in at least one of a lower portion of the front cover and a lower portion of the back cover.

2. The cover case for an electronic shelf label according to claim 1, wherein one or more projecting portions are formed in the lower portion of the front cover to project toward the back cover.

3. The cover case for an electronic shelf label according to claim 2, wherein the front cover comprises:
a display cover formed in a position facing the display portion; and
a label cover formed in a position facing the inserted label.

4. The cover case for an electronic shelf label according to claim 3, wherein the first separation portion is formed in an upper portion of the label cover,
the second separation portion is formed in a lower portion of the label cover, and the projecting portion is formed to project from the lower portion of the label cover toward the back cover.

5. The cover case for an electronic shelf label according to claim 3, wherein the lower portion of the label cover has a round shape.

6. The cover case for an electronic shelf label according to claim 1, wherein one or more projecting portions are formed in the lower portion of the back cover to project toward the front cover.

7. The cover case for an electronic shelf label according to claim 6, wherein the front cover comprises:
a display cover formed in a position facing the display portion; and
a label cover formed in a position facing the inserted label.

8. The cover case for an electronic shelf label according to claim 7, wherein the first separation portion is formed in the upper portion of the label cover,
the second separation portion is formed in the lower portion of the label cover, and the projecting portion is formed to project from the lower portion of the back cover toward the label cover.

9. The cover case for an electronic shelf label according to claim 1, wherein one or more projecting portions are formed in the lower portion of the front cover and the lower portion of the back cover and comprises a first projecting portion formed to project from the lower portion of the front cover toward the back cover and a second projecting portion formed to project from the lower portion of the back cover toward the front cover.

10. The cover case for an electronic shelf label according to claim 9, wherein the first projecting portion and the second projecting portion are coupled with each other.

11. The cover case for an electronic shelf label according to claim 9 or claim 10, wherein the front cover comprises:
a display cover formed in a position facing the display portion; and
a label cover formed in a position facing the inserted label.

12. The cover case for an electronic shelf label according to claim 11, wherein the first separation portion is formed in the upper portion of the label cover,
the second separation portion is formed in the lower portion of the label cover, the first projecting portion is formed to project from the lower portion of the label cover toward the back cover, and
the second projecting portion is formed to project from the lower portion of the back cover toward the label cover.

13. The cover case for an electronic shelf label according to any of claims 2, 6, 9 or 10, wherein side surfaces of the front cover and the back cover are coupled with each other.

14. The cover case for an electronic shelf label according to any of claims 2, 6, 9 or 10, wherein the front cover and the back cover are coupled with each other to seal the display portion.

15. The cover case for an electronic shelf label according to any of claims 2, 6, 9 or 10, wherein the lower portion of the front cover has a round shape.

16. The cover case for an electronic shelf label according to claim 7 or claim 11, wherein the lower portion of the label cover has a round shape.

17. An electronic shelf label comprising:
a circuit unit comprising a display portion for displaying product information; and a cover case for detachably receiving the circuit unit, wherein the cover case comprises:
a front cover for covering a front surface of the display portion; and
a back cover for covering a back surface of the display portion, wherein
the front cover and the back cover are coupled with each other so that a first separation portion for inserting a label having product information printed thereon is formed in an upper portion thereof and a second separation portion is formed in a lower portion thereof while being coupled with each other in a state of receiving the circuit unit, and
a projecting portion is formed in at least one of a lower portion of the front cover and a lower portion of the back cover.
